# EUROPEAN PATENT APPLICATION

(11) **EP 0 758 708 A1**
(43) Date of publication of application: **19.02.1997**
(21) Application number: 96500117.5
(22) Date of filing: 09.08.1996
(51) Int. Cl.: E05F 15/00, H03K 17/97

(54) **Anti-nipping device**

(30) Priority: 11.08.1995 ES 9501647
(71) Applicant: IRAUSA INGENIERIA, S.A., E-09007 Burgos (ES)
(72) Inventor: Irazusta Saez, Patricia, 20009 San Sebastian (ES)
(74) Representative: Urteaga Simarro, José Antonio

(57) **Abstract**

An antinipping device which uses an electronic module (1), a motor-reducer (2), a guide (3) and a drive plate (4) for the vehicle window, together with drive wiring (8) and electrical wiring (9). A magnet (10) and a sensor (11) are placed, opposite and adjacent to each other, and the drive plate holds a ferromagnetic plate (13) provided with a wing (14) that cuts off the current when the magnet and the sensor are opposite each other or shuts off the current when they are adjacent to each other.

## Description

The invention relates to an antinipping device applicable to the door windows, sliding roofs, etc. of vehicles, in particular of automobile vehicles.

Within this field, and already known through Spanish patent application number P.9201697, is an antinipping system which uses sensors located at specific points of the window winder or regulator slide guide, for instance, which in combination with a magnet housed in the drive plate, come opposite the passage of the said magnet, emitting a signal which reaches the electronic module, for this to operate in consequence, on the ends that determine the termination of the antinipping area.

Therefore, the signal emitted is instantaneous, which on specific occasions for certain assemblies is not advisable.

The fundamental objectives of the invention are to provide an antinipping device that emits a signal for a longer period of time, in order to eliminate possible pick-up errors, while also providing greater reliability and making it more difficult to replace or deceive.

In order to achieve these objectives, the device of the invention can use any kind of pick-up or sensor, not being limited to Hall effect pick-ups. Any electric and/or electronic componenet that has at least a bistable operation and can give an electrical signal is valid.

The signals that the electronic module receives derived from the passage or not of the magnetic flow can be instantaneous, interpretable only by being detected at a certain moment, or permanent for the time desired.

It is not necessary for the magnet and the sensor in the position pick-up to be facing each other. The system can use a ferromagnetic plate whose purpose is to either cut off or to allow the passage of the flow the magnetic field between the said magnet and sensor. Through this ferromagnetic plate arranged on the drive slide, which is of variable length, the cutting off of the direct flow between the magnet and the sensor is carried out when these are facing or opposite each other at the points desired, in such a way that this cutting off of the flow, in the time during which the plate is circulating, determines the signal to the electronic module.

When the magnet and the sensor are not facing or opposite each other, the drive plate, on passing close to both, connects both flows, providing the appropriate opportune signal to the module.

The signal is therefore in operation for a longer time than the length of the plate, with this permanent characteristic being extendible when other kinds of pick-ups or sensors are used, such as electric switches, etc.

To determine the elimination of the antinipping in the upper area, in the lower area and in the window gaps or openings (in the case of sunroofs), the position can be adjusted to the start of the upper rubber elements, where the current intake would rise in such a way that it could be interpreted as antinipping, as it is defined in the operating concept.

With all doors and windows, even those of one same model, being different, the difficulty involved in the arrangement of these antinipping end pickups or sensors is understood. The general value has to be less than some 4 mm. from the upper stop of the vehicle window.

As the upper stop in each door is different, in accordance with what was mentioned previously, due to their different patterns, the window winder will take the upper stop as its reference point, with a different one for each window winder. For this purpose, the 4 mm. is a variable measurement in this range, whose position the system will know how to determine.

On raising the vehicle window in the door for the first time, for example, the position of the electric/ electronic pick-up would be displaced by any mechanical means into the desired position.

All these and other details will be understood with greater clarity with reference to the accompanying sheets of drawings, in which the following are represented, with a non-restrictive nature.
- Figure 1 is a general view of a mechanical installation of an antinipping device.
- Figure 2 is a diagrammatic representation of the relationship between the drive slide and the magnet-sensor assembly when these latter two items are facing or opposite each other.
- Figure 3 shows the variant of the device of the invention, according to which the ferromagnetic plate carries out the shutting off or the transmission of the magnetic flow.
- Figure 4, finally, represents a section of the drive slide, prepared in this case for the action of an electric/electronic switch.

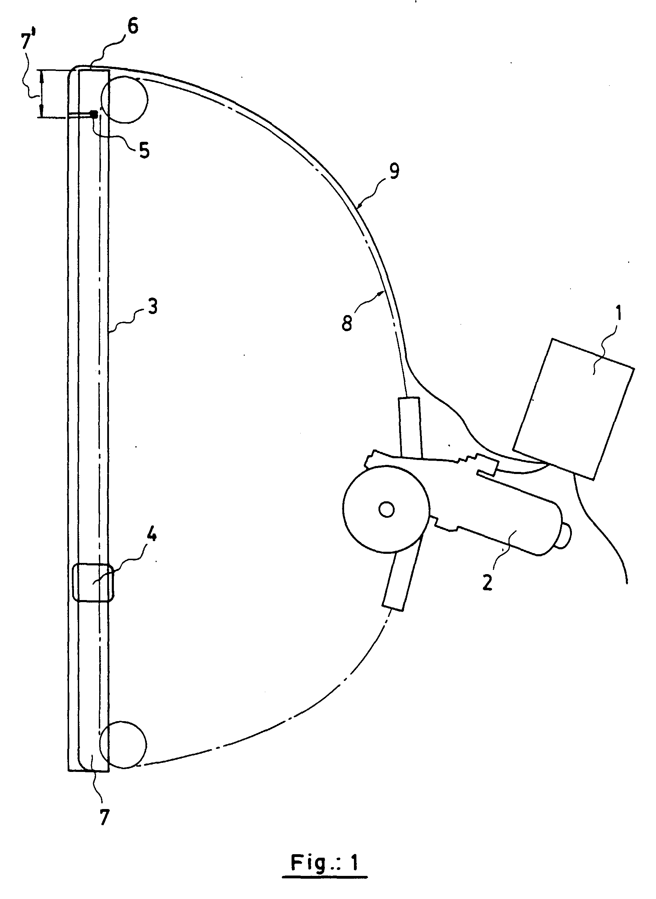

Looking now Figure 1, a unit is shown, made up of an electronic module (1) connected, by means of wiring (9) to a motor (2) and to the area of the guide (3) for the window winder or regulator. At the ends of the guide, the upper and lower stops (6,7) can be seen, as can the drive slide (4), which traverses along the said guide, all of which is connected to the drive wiring (8).

An end antinipping zone is indicated by the position (7'), at the start of which the detecting pick-up (5), which is responsible for transmitting the appropriate signal to the electronic module (1), can be observed.

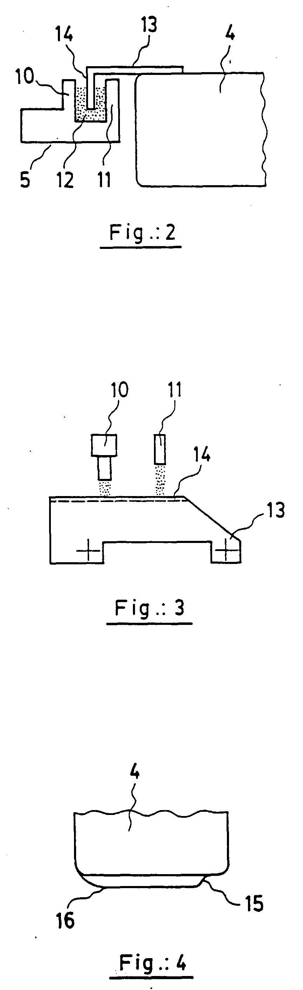

According to Figure 2, we can appreciate how the ferromagnetic plate (13) is secured to the drive slide (4). The wing (14) of this plate passes through a pick-up area (5) in which a flow (12) is established between the magnet and the sensor (10,11). The length of the plate will determine, as was stated previously, the time of duration of the signal emitted to the electronic module by this interruption in order to determine the end of the antinipping.

The variant shown in Figure 3 represents the plate (13), that passes close to the magnet and sensor (10,11), which in this case are not facing or opposite each other, but placed adjacent to each other. The flows emitted are connected by the passing of the plate and during the time that it is passing.

The slide in Figure 4 shows the particular protruding (16) shape of the side of the slide (4) when the pick-up consists of a switch, with this portion (15,16) being applied, by contact, against the part of the said switch which is to actuated.

It is important to point out, once having described the nature and advantages of this invention, its non-restrictive character, inasmuch as changes in the shape, materials or dimensions of its constituent parts will not in any way alter its essence, as long as they do not mean a substantial variation of the whole assembly.

## Claims

1. Antinipping device, which has an electronic module (1), a motor-reducer (2) and a guide (3) for a window drive plate (4), with sensors on the guide and a magnet on the drive slide or plate, with electric wiring (9) and other drive wiring (8), which is characterized in that the magnet (10) and the sensor (11) are arranged facing or opposite each other at least one of the ends of the rail or track and connected to the electronic module by means of wiring, while the drive slide (4) includes an ferromagnetic plate (13) provided with a wing (14) that passes through the space between the sensor and the magnet for a certain time, depending on the length of the said plate.

2. Antinipping device, in accordance with claim 1, characterized in that the sensor (11) and the magnet (10) are not facing or opposite each other and the ferromagnetic plate (13,14) closes the flow as it passes through the position of both items.

3. Antinipping device, in accordance with claim 1,characterized in that an electric/electronic component is used, provided with a bistable operation capable of producing a signal, with this component being operated by means of a projection (15,16) made on the drive slide (4).

4. Antinipping device, in accordance with claims 1,2 and 3, characterized in that in order to determine the end of the antinipping area, the pick-up unit is situated close to the start of the rubber elements of the door.
